(19) Europäisches Patentamt / European Patent Office / Office européen des brevets

(11) **EP 1 783 915 B1**

(12) **FASCICULE DE BREVET EUROPEEN**

(45) Date de publication et mention
de la délivrance du brevet:
**17.06.2009 Bulletin 2009/25**

(51) Int Cl.:
**H03M 1/10** *(2006.01)*

(21) Numéro de dépôt: **06123109.8**

(22) Date de dépôt: **27.10.2006**

(54) **Dispositif de test d'un convertisseur analogique-numérique**

Testgerät für einen Analog-/Digitalwandler

Device for testing an analog-/digital converter

(84) Etats contractants désignés:
**DE GB**

(30) Priorité: **28.10.2005 FR 0553295**

(43) Date de publication de la demande:
**09.05.2007 Bulletin 2007/19**

(73) Titulaire: **DOLPHIN INTEGRATION**
**F-38240 Meylan (FR)**

(72) Inventeur: **Compagne, Eric**
**38920 Crolles (FR)**

(74) Mandataire: **de Beaumont, Michel**
**1bis, rue Champollion**
**38000 Grenoble (FR)**

(56) Documents cités:
**US-B1- 6 498 998**

• **HUANG F ET AL: "Analog signal generator for BIST of wideband IF signals bandpass sigma-delta modulator" MICROELECTRONICS JOURNAL, MACKINTOSH PUBLICATIONS LTD. LUTON, GB, vol. 34, no. 1, 1 janvier 2003 (2003-01-01), pages 85-91, XP004404374 ISSN: 0026-2692**
• **BELCHER R A: "Multi-tone testing of quantisers using PRBS signals" COMPUTER STANDARDS AND INTERFACES, ELSEVIER SEQUOIA. LAUSANNE, CH, vol. 22, no. 4, 1 octobre 2000 (2000-10-01), pages 269-279, XP004208691 ISSN: 0920-5489**
• **ROY A ET AL: "High accuracy stimulus generation for A/D converter BIST" PROCEEDINGS INTERNATIONAL TEST CONFERENCE 2002. ITC 2002. BALTIMORE, MD, OCT. 7-10, 2002, INTERNATIONAL TEST CONFERENCE, NEW YORK, NY : IEEE, US, 7 octobre 2002 (2002-10-07), pages 1031-1039, XP010609836 ISBN: 0-7803-7542-4**
• **PATENT ABSTRACTS OF JAPAN vol. 010, no. 334 (P-515), 13 novembre 1986 (1986-11-13) & JP 61 138173 A (MATSUSHITA ELECTRIC IND CO LTD), 25 juin 1986 (1986-06-25)**

**Description**

Domaine de l'invention

La présente invention concerne un dispositif de test d'un convertisseur analogique-numérique (CAN).

Exposé de l'art antérieur

Un test classique d'un convertisseur analogique-numérique consiste à déterminer le rapport signal sur bruit plus distorsion du convertisseur (de l'anglais Signal to Noise And Distortion ratio ou SINAD). Le terme distorsion correspond aux composantes fréquentielles présentes dans le signal de sortie autres que les composantes fréquentielles du signal d'entrée. De telles composantes fréquentielles supplémentaires proviennent du fait que le convertisseur n'est pas parfaitement linéaire. Ceci peut être obtenu par l'intermédiaire d'un dispositif de test relié temporairement au convertisseur et qui fournit au convertisseur un signal sinusoïdal, mémorise des échantillons fournis par le convertisseur et détermine, à partir des échantillons mémorisés, le contenu spectral ou fréquentiel du signal numérique fourni par le convertisseur à partir duquel est déterminé le rapport signal sur bruit plus distorsion. Le contenu spectral ou fréquentiel peut être obtenu par la détermination de la transformée de Fourier rapide du signal numérique fourni par le convertisseur.

Un inconvénient d'un tel test est que la détermination de la transformée de Fourier rapide nécessite l'acquisition d'un nombre important d'échantillons, par exemple de 10000 à 20000 dans le cas d'une application audio. En outre, la durée d'un test mettant en oeuvre la détermination de la transformée de Fourier rapide n'est généralement pas négligeable. A titre d'exemple, pour une application audio pour laquelle la fréquence d'échantillonnage du convertisseur est égale à 48 kHz, la durée d'un test est généralement supérieure à 1 seconde. Sachant que le coût d'un test est directement lié à sa durée, le coût d'un test mettant en oeuvre la détermination d'une transformée de Fourier rapide est généralement élevé par rapport au coût du circuit lui-même.

Dans de nombreuses applications, on utilise un convertisseur analogique-numérique du type $\Sigma$-$\Delta$. Un dispositif de test d'un convertisseur analogique-numérique sigma delta est divulgué par Huang et al. dans " Analog signal generator for BIST of wideband IF signals bandpass sigma-delta modulator", Microelectronics Journal, Mackintosh Publications Ltd. Un tel convertisseur comprend un modulateur $\Sigma$-$\Delta$, qui fournit un signal généralement binaire à une fréquence supérieure à la fréquence d'échantillonnage du convertisseur, et un étage de filtrage et de décimation qui fournit un signal numérique codé sur plusieurs bits à la fréquence d'échantillonnage et élimine le bruit de quantification hors de la bande de signal utile. Un avantage d'un tel convertisseur est qu'il peut être entièrement réalisé par un circuit intégré numérique ne comportant pas d'éléments analogiques dont les caractéristiques techniques doivent être définies avec précision.

Pour diminuer le coût du test d'un convertisseur analogique numérique, il serait souhaitable que le convertisseur comprenne son propre dispositif de test de façon qu'une opération de test soit mise en oeuvre automatiquement lors du fonctionnement du convertisseur. En particulier, lorsque le convertisseur est réalisé par un circuit intégré, il serait souhaitable que le dispositif de test puisse être réalisé de façon intégrée pour être associé au convertisseur. Toutefois, la réalisation d'un circuit intégré effectuant la détermination de la transformée de Fourier rapide est relativement complexe et requiert une surface de silicium importante dont le coût peut s'avérer excessif.

Résumé de l'invention

La présente invention vise un dispositif de test d'un convertisseur analogique-numérique permettant la détermination du rapport signal sur bruit plus distorsion ou du rapport signal sur bruit qui est susceptible d'être réalisé de façon intégrée à coût réduit.

Dans ce but, elle prévoit un dispositif de test d'un convertisseur analogique-numérique fournissant un signal numérique à une fréquence d'échantillonnage donnée, comprenant un module de fourniture d'un signal de test au convertisseur, le signal de test étant un signal périodique comportant des composantes fréquentielles seulement à une fréquence fondamentale et à des harmoniques de la fréquence fondamentale, la fréquence fondamentale étant un multiple du quart de la fréquence d'échantillonnage ; un filtre adapté à recevoir le signal numérique et à rejeter la fréquence fondamentale pour fournir un signal numérique filtré ; et un module adapté à recevoir le signal numérique et le signal numérique filtré et à fournir un signal représentatif du rapport entre les puissances efficaces du signal numérique et du signal numérique filtré.

Selon un exemple de réalisation de l'invention, le module de fourniture du signal de test est adapté à fournir un signal comprenant seulement des composantes fréquentielles à la fréquence fondamentale et à des harmoniques impaires de la fréquence fondamentale.

Selon un exemple de réalisation de l'invention, le module de fourniture du signal de test est adapté à fournir un signal carré et périodique.

Selon un exemple de réalisation de l'invention, le module de fourniture du signal de test est adapté à fournir un signal dont la fréquence fondamentale est égale au quart ou à la moitié de la fréquence d'échantillonnage.

Selon un exemple de réalisation de l'invention, le convertisseur comprend un étage de filtrage équivalent à un filtre passe-bas dont la fréquence de coupure est égale à la moitié de la fréquence d'échantillonnage.

Selon un exemple de réalisation de l'invention, le convertisseur est du type sigma-delta.

La présente invention prévoit également un procédé de test d'un convertisseur analogique-numérique fournissant un signal numérique à une fréquence d'échantillonnage donnée, comprenant les étapes consistant à fournir au convertisseur un signal de test correspondant à un signal périodique comportant des composantes fréquentielles seulement à une fréquence fondamentale et à des harmoniques, la fréquence fondamentale étant un multiple du quart de la fréquence d'échantillonnage ; à filtrer le signal numérique pour rejeter la fréquence fondamentale ; et à déterminer le rapport entre les puissances efficaces du signal numérique et du signal numérique filtré.

Selon un exemple de réalisation de l'invention, le signal de test comprend seulement des composantes fréquentielles à la fréquence fondamentale et à des harmoniques impaires de la fréquence fondamentale.

Selon un exemple de réalisation de l'invention, la fréquence fondamentale est égale au quart ou à la moitié de la fréquence d'échantillonnage.

Selon un exemple de réalisation de l'invention, le convertisseur réalise un filtrage du signal numérique du type passe bas à une fréquence de coupure égale à la moitié de la fréquence d'échantillonnage.

Brève description des dessins

Cet objet, ces caractéristiques et avantages, ainsi que d'autres de la présente invention seront exposés en détail dans la description suivante d'exemples de réalisation particuliers faite à titre non-limitatif en relation avec les figures jointes parmi lesquelles :

la figure 1 représente schématiquement un exemple de dispositif de test d'un convertisseur analogique-numérique ;
la figure 2 représente un exemple de réalisation d'un dispositif de test d'un convertisseur analogique-numérique selon l'invention ;
la figure 3 représente schématiquement un exemple de réalisation d'un convertisseur $\Sigma$-$\Delta$ ;
la figure 4 représente un exemple de gabarit d'un étage de filtrage du convertisseur de la figure 3 ;
la figure 5 représente, dans le domaine fréquentiel, un exemple de signal analogique carré et périodique ;
la figure 6 représente, dans le domaine fréquentiel, un exemple de signal fourni par un convertisseur analogique-numérique recevant un signal carré et périodique de fréquence 10 kHz ;
la figure 7 représente une variante de réalisation du dispositif de test selon l'invention ; et
les figures 8 et 9 représentent, dans le domaine fréquentiel, des exemples de signaux utilisés par le dispositif de test selon l'invention.

Description détaillée

Par souci de clarté, de mêmes éléments ont été désignés par de mêmes références aux différentes figures.

Une première tentative de la demanderesse a consisté à réaliser un dispositif de test d'un convertisseur analogique-numérique permettant la détermination du rapport signal sur bruit plus distorsion et fonctionnant selon le principe d'un distorsiomètre.

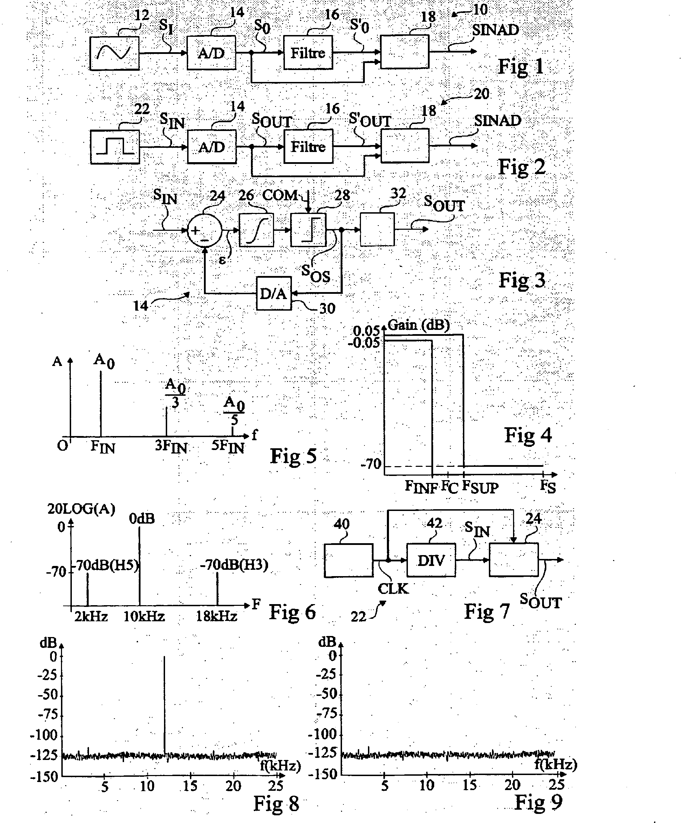

La figure 1 représente un exemple de réalisation d'un tel dispositif de test 10 du type distorsiomètre qui comprend un module 12 de fourniture d'un signal SI analogique sinusoïdal de fréquence $F_I$ à un convertisseur analogique-numérique 14 qui fournit un signal numérique $S_O$ correspondant à une succession de valeurs numériques à une fréquence d'échantillonnage $F_S$. Le signal $S_O$ est fourni à un filtre réjecteur 16 numérique qui est adapté à rejeter la fréquence $F_I$ du signal numérique $S_O$ et à fournir un signal numérique filtré $S_O$'. Un module 18 de détermination du rapport signal sur bruit plus distorsion reçoit les signaux $S_O$ et $S_O$' et détermine la puissance efficace du signal $S_O$ et la puissance efficace du signal $S_O$', et fournit un signal SINAD correspondant au rapport entre les deux puissances efficaces qui est représentatif du rapport signal sur bruit plus distorsion du convertisseur 14. En effet, un signal sinusoïdal étant représenté dans le domaine fréquentiel par une raie à la fréquence $F_I$, le signal $S_O$' fourni par le filtre 16 contient seulement le bruit et les composantes de distorsion dus au convertisseur 14.

Un avantage d'un tel dispositif de test est qu'il nécessite un nombre réduit d'échantillons pour fournir une valeur du rapport signal sur bruit plus distorsion. Par exemple, pour une application audio, un nombre de 500 à 1000 échantillons est suffisant. La durée d'un test est donc moins importante que pour un test mettant en oeuvre une transformée de Fourier rapide.

Un inconvénient d'un tel dispositif de test 10 est qu'il est difficile de le réaliser sous la forme d'un circuit intégré qui serait associé au convertisseur 14. En effet, si le filtre numérique 16 et le module 18 de détermination du rapport signal sur bruit plus distorsion peuvent facilement être réalisés de façon intégrée tout en occupant une surface de silicium réduite, il est difficile de réaliser de façon intégrée le module 12 de fourniture du signal sinusoïdal. En effet, il est difficile de réaliser un circuit intégré à faible coût fournissant un signal analogique sinusoïdal de fréquence précise et ajustable. En outre, il serait nécessaire de prévoir des circuits de test spécifiques du module 12 de fourniture du signal sinusoïdal pour en vérifier le bon fonctionnement, ce qui compliquerait encore davantage la réalisation du dispositif de test 10.

Pour parvenir à l'obtention d'un dispositif de test de type distortiomètre susceptible d'être réalisé de façon intégrée à coût réduit, la demanderesse a mis en évidence qu'il fallait mettre en oeuvre un signal de test spécifique, autre que sinusoïdal, fourni au convertisseur analogique-numérique pour la détermination du rapport signal sur bruit plus distorsion. La demanderesse a mis en évidence que, pour une certaine catégorie de convertisseurs analogique-numérique, la fourniture d'un signal de test périodique ayant uniquement une fréquence fondamentale et des harmoniques paires et/ou impaires, permet la fourniture d'un signal numérique par le convertisseur dont la transformée de Fourier est identique à celle qui serait obtenue en attaquant le convertisseur par un signal sinusoïdal pour une fréquence fondamentale judicieusement choisie par rapport à la fréquence d'échantillonnage du convertisseur.

Par la suite, la présente invention va être décrite plus en détail pour un convertisseur analogique-numérique de type $\Sigma$-$\Delta$ et pour un signal de test carré et périodique.

La figure 2 représente un exemple de réalisation d'un dispositif de test 20 selon l'invention dans lequel le dispositif de test 20 comprend un module 22 qui fournit un signal $S_{IN}$ carré et périodique de fréquence FIN au convertisseur 14. Le convertisseur 14 fournit un signal numérique $S_{OUT}$ correspondant à une succession de valeurs numériques à la fréquence d'échantillonnage $F_S$. Le signal $S_{OUT}$ attaque le filtre 16 qui fournit un signal filtré $S_{OUT}$'. Le module 18 de détermination du rapport signal sur bruit plus distorsion reçoit les signaux $S_{OUT}$ et $S_{OUT}$' et fournit le signal SINAD représentatif du rapport signal sur bruit plus distorsion du convertisseur 14.

La figure 3 représente un exemple de réalisation du convertisseur $\Sigma$-$\Delta$ 14 dans lequel le convertisseur 14 comprend un soustracteur 24 dont l'entrée positive (+) reçoit le signal $S_{IN}$ et qui fournit un signal $\varepsilon$ à un intégrateur 26. L'intégrateur 26 attaque un comparateur 28 qui fournit un signal binaire $S_{OS}$ à la fréquence d'un signal de commande COM qui est plus élevée que la fréquence d'échantillonnage $F_S$. Le signal $S_{OS}$ binaire est reconverti en signal analogique par un convertisseur numérique-analogique 30 qui attaque l'entrée négative (-) du soustracteur 24. Le signal binaire $S_{OS}$ est fourni à un module 32 de décimation et de filtrage qui fournit le signal numérique $S_{OUT}$ sur plusieurs bits à la fréquence $F_S$ tout en réalisant une opération de filtrage pour rejeter le bruit de quantification dû au comparateur 28 en dehors de la bande de fréquence utile du signal.

La figure 4 représente un exemple du gabarit du filtre équivalent au module 32 de décimation et de filtrage. Il s'agit du gabarit d'un filtre passe-bas qui comprend une fréquence de coupure $F_C$ égale à $F_S/2$, et qui assure une atténuation supérieure à 70 dB pour une fréquence supérieure à $F_{SUP}$ et une atténuation inférieure à 0,05 dB pour une fréquence inférieure à $F_{INF}$. A titre d'exemple, pour une application audio, les fréquences $F_S$, $F_C$, $F_{SUP}$ et $F_{INF}$ sont respectivement égales à 48 kHz, 24kHz, 30 kHz et 19 kHz.

On va maintenant décrire la démarche mise en oeuvre par la demanderesse pour la détermination de la fréquence FIN du signal $S_{IN}$ à utiliser pour permettre la détermination convenable du signal SINAD. Un signal $S_{IN}$ carré et périodique de rapport cyclique 1/2 et de fréquence FIN peut se décomposer en une somme de signaux sinusoïdaux selon la relation suivante :

$$S_{IN}(t) = \sum_{k=0}^{\infty} \frac{A_0}{2k+1} \sin((2k+1)(2\pi F_{IN}t))$$

La figure 5 représente de façon classique l'expression dans le domaine fréquentiel du signal $S_{IN}$. On obtient une succession de raies d'amplitude décroissante, la raie de fréquence FIN correspondant à la raie fondamentale et les raies de fréquences supérieures correspondant aux harmoniques impaires (seuls les harmoniques 3 et 5 étant représentées).

Si on fournit au convertisseur 14 un signal $S_{IN}$ carré et périodique de fréquence FIN quelconque à la place d'un signal sinusoïdal, le signal $S_{OUT}$ obtenu comprend les harmoniques impaires du signal $S_{IN}$ qui n'ont pas été filtrées par le module 32 de décimation et de filtrage du convertisseur 14. Comme le filtre 16 est défini de façon à rejeter la fréquence fondamentale FIN du signal $S_{OUT}$, le signal $S_{OUT}$' comprend non seulement le bruit et les composantes de distorsion mais aussi certaines harmoniques impaires. Le signal SINAD déterminé à partir de la puissance efficace du signal $S_{OUT}$' ne correspond alors plus au rapport signal sur bruit plus distorsion du convertisseur 14 et ne peut pas être utilisé pour en déterminer le bon fonctionnement.

Une première approche consisterait à choisir la fréquence FIN du signal $S_{IN}$ suffisamment élevée pour que toutes les harmoniques qui se trouvent à des fréquences supérieures à la fréquence de coupure $F_C$ du module 32 soient filtrées. Toutefois, le convertisseur 14 réalisant une opération d'échantillonnage à la fréquence $F_S$ et le module 32 ne réalisant qu'une atténuation, et non une suppression, des fréquences supérieures à la fréquence de coupure $F_C$, on observe un repliement des harmoniques du signal $S_{OUT}$ de sorte que certaines harmoniques au-delà de la fréquence de coupure $F_C$ peuvent être repliées dans la bande de fréquence utile (c'est-à-dire la bande de fréquence qui s'étend jusqu'à $F_C$). Bien que les harmoniques repliées soient atténuées par le module 32, elles n'ont pas une amplitude négligeables et le signal SINAD n'est alors plus représentatif du rapport signal sur bruit plus distorsion du convertisseur 14.

La figure 6 illustre un tel phénomène de repliement et représente, dans le domaine fréquentiel, le signal $S_{OUT}$ fourni par le convertisseur 14 à partir d'un signal carré $S_{IN}$ à une fréquence FIN égale à 10 kHz, la fréquence d'échantillonnage $F_S$ étant égale à 48 kHz et la fréquence de coupure $F_C$ étant égale à 24 kHz. On retrouve bien une raie à 10 KHz, correspondant à la fréquence fondamentale et qui n'est pas filtrée par le convertisseur 14. Toutefois, l'harmonique 3 (H3) du signal $S_{IN}$, à 30 kHz, est repliée lors de l'échantillonnage et fournit une raie à 18 kHz atténuée de 70 dB. De même, l'harmonique 5 (H5) du signal $S_{IN}$ qui se trouve à 50 kHz est repliée et fournit une raie à 2 kHz atténuée de 70 dB. De telles raies, qui ne sont pas dues à un défaut de linéarité du convertisseur 14, ne sont pas filtrées par le filtre 16 et se retrouvent donc dans le signal $S_{OUT}$,' fourni au module 18 de détermination du rapport signal sur bruit plus distorsion.

La présente invention consiste à attaquer le convertisseur 14 avec un signal carré $S_{IN}$ tel que les harmoniques du signal $S_{OUT}$ se replient exactement sur la fréquence fondamentale. De cette façon, après rejet de la fréquence fondamentale par le filtre 16, le signal $S_{OUT}$' comporte uniquement le bruit et les composantes fréquentielles de distorsion introduits par le convertisseur 14.

Une fréquence de repliement $F_{OUT}$ est obtenue à partir d'une fréquence $F_H$ d'entrée, en déterminant un coefficient k selon la relation suivante :

$$kF_S/2 \le F_H \le (k+1)F_S/2$$

On obtient alors la fréquence $F_{OUT}$ de repliement de la façon suivante :

si k est un entier impair :

$$F_{OUT} = (k+1)F_S/2 - F_H \quad (1)$$

si k est un entier pair :

$$F_{OUT} = F_H - kF_S/2 \quad (2)$$

Selon l'invention, la fréquence fondamentale FIN du signal carré $S_{IN}$ fourni au convertisseur 14 est déterminée de sorte que l'harmonique 3 se replie sur la fréquence fondamentale. La relation (1) donne, pour k impair :

$$F_{IN} = (k+1)F_S/2 - 3F_{IN} \text{ soit } F_{IN} = (k+1)F_S/8$$

La relation (2) donne, pour k pair :

$$F_{IN} = 3F_{IN} - kF_S/2 \text{ soit } F_{IN} = kF_S/4$$

On retient les solutions pour lesquelles la fréquence FIN est inférieure à la fréquence de coupure $F_C = F_S/2$ du convertisseur 14, c'est-à-dire :

$$F_{IN} = F_S/4 \text{ ou } F_{IN} = F_S/2$$

De façon analogue, on montre que pour FIN = $F_S/4$ et $F_{IN} = F_S/2$, toutes les harmoniques impaires sont repliées sur FIN.

5

Pour un signal $S_{IN}$ carré et périodique dont la fréquence fondamentale est $F_S/4$ ou $F_S/2$, toutes les harmoniques du signal $S_{IN}$ sont repliées par le convertisseur 14 sur la fréquence FIN. Le spectre du signal $S_{OUT}$ est donc identique au spectre qui aurait été obtenu en appliquant à l'entrée du convertisseur 14 un signal sinusoïdal de fréquence $F_{IN}$.

En utilisant un signal $S_{IN}$ carré de fréquence $F_S/4$, une raie correspondant à l'harmonique 2, c'est-à-dire à $F_S/2$, peut apparaître due à la distorsion introduite par le convertisseur 14. Une telle raie, se trouvant dans la bande utile, n'est pas filtrée par le module de filtrage et de décimation 32. Le signal filtré $S_{OUT}$' contient alors du bruit et la composante d'harmonique 2 due à la distorsion. En outre, les harmoniques paires, dues à la distorsion, d'ordre supérieur à 2 sont repliées sur la fréquence nulle ou sur la fréquence $F_S/2$. En utilisant un signal $S_{IN}$ carré de fréquence $F_S/2$, les raies correspondant à des harmoniques paires dues à la distorsion introduite par le convertisseur 14 ne se trouvent pas dans la bande utile et sont repliées sur la fréquence nulle. Lors de la détermination du signal SINAD, en particulier lors de la détermination de la puissance efficace du signal $S_{OUT}$', la composante à la fréquence nulle n'est généralement pas prise en compte, la puissance efficace étant déterminée à partir du signal $S_{OUT}$' diminué de sa valeur moyenne. Le signal SINAD est alors représentatif du rapport signal sur bruit du convertisseur 14. En appliquant successivement le signal $S_{IN}$ de fréquence FIN égale à $F_S/4$ et $F_S/2$, on peut déterminer, à partir des valeurs du signal SINAD obtenues, la distorsion introduite par le convertisseur 14.

Pour éviter des bruits parasites qui ne seraient pas dus au convertisseur 24 mais à des variations de la fréquence du signal $S_{IN}$ (phénomène généralement appelé jitter) par rapport au signal COM qui commande le fonctionnement du convertisseur 14, il est souhaitable que le signal $S_{IN}$ soit synchrone avec le signal COM.

La figure 7 représente un exemple de réalisation dans lequel le module 22 de fourniture du signal de test $S_{IN}$ comprend un module 40 qui fournit un signal d'horloge CLK, carré et périodique à une fréquence élevée, à un diviseur 42 qui divise le signal d'horloge CLK jusqu'à obtenir le signal $S_{IN}$. Le signal d'horloge CLK est fourni par ailleurs au convertisseur 14 pour l'obtention du signal de commande COM. A titre d'exemple, pour une fréquence d'échantillonnage $F_S$ égale à 48 kHz, le signal d'horloge CLK peut être un signal carré de fréquence 12,288 MHz. Le diviseur 42 effectue alors une division par 1024 pour obtenir le signal $S_{IN}$ à une fréquence de 12 KHz. Le signal $S_{IN}$ est alors synchrone avec le signal COM.

Les figures 8 et 9 représentent, dans le domaine fréquentiel, les signaux $S_{OUT}$ et $S_{OUT}$' obtenus lorsque le convertisseur 14 a une fréquence d'échantillonnage $F_S$ égale à 48 kHz et une fréquence de coupure $F_C$ égale à 24 kHz et est attaqué par un signal $S_{IN}$ carré et périodique de fréquence FIN égale à 12 kHz. On remarque que le signal $S_{OUT}$ comprend une seule raie à $F_S/4=12$ kHz et, pour le signal $S_{OUT}$', la composante fondamentale à la fréquence $F_S/4$ a été supprimée par le filtre 26.

La présente invention a été décrite pour la fourniture d'un signal $S_{IN}$ correspondant à un signal carré périodique de rapport cyclique 0,5. Un tel signal $S_{IN}$ présente l'avantage qu'il peut être très facilement obtenu au moyen de commutateurs reliés à des sources de tension et par division à partir du signal d'horloge utilisé pour la commande du convertisseur. Toutefois, la présente invention peut être mise en oeuvre en utilisant un signal $S_{IN}$ carré et périodique et de rapport cyclique différent de 0,5. En outre, la présente invention peut également être mis en oeuvre en utilisant un signal $S_{IN}$ périodique de forme triangulaire. En effet, de tels signaux ne comportent, dans le domaine fréquentiel, que des harmoniques impaires de la fréquence fondamentale. En choisissant la fréquence FIN de façon adaptée comme cela a été précédemment décrit, le signal $S_{OUT}$ obtenu ne comporte également qu'une raie à la fréquence FIN permettant une détermination correcte du rapport signal sur bruit plus distorsion.

De façon plus générale, la présente invention peut être mise en oeuvre avec tout signal $S_{IN}$ périodique qui comprend des harmoniques paires et impaires et dont l'obtention est plus simple que l'obtention d'un signal sinusoïdal, et, en particulier, tout signal $S_{IN}$ pouvant être fourni par un circuit pouvant facilement être réalisé de façon intégrée. En effet, pour un tel signal, en fixant la fréquence FIN à $F_S/2$, toutes les harmoniques paires sont repliées sur la fréquence nulle qui n'est pas prise en compte lors de la détermination du signal SINAD. En outre, de façon analogue à ce qui a été décrit précédemment, les harmoniques impaires sont repliées sur la fréquence fondamentale $F_S/2$ et sont donc filtrées par le filtre 16.

La présente invention a été décrite pour un convertisseur 14 de type $\Sigma$-$\Delta$. Toutefois, la présente invention peut être appliquée à tout type de convertisseur qui comprend un étage de filtrage réalisant un filtrage de type passe-bas supprimant le bruit hors bande utile.

**Revendications**

1. Dispositif de test (20) d'un convertisseur analogique-numérique (14) fournissant un signal numérique ($S_{OUT}$) à une fréquence d'échantillonnage ($F_S$) donnée, comprenant :

   un module (22) de fourniture d'un signal de test ($S_{IN}$) au convertisseur, **caractérisé en ce que** le signal de test est un signal périodique comportant des composantes fréquentielles seulement à une fréquence fondamentale

($F_{IN}$) et à des harmoniques de la fréquence fondamentale, la fréquence fondamentale étant un multiple du quart de la fréquence d'échantillonnage ;

et **en ce qu'**il comprend :

un filtre (16) adapté à recevoir le signal numérique et à rejeter la fréquence fondamentale pour fournir un signal numérique filtré ($S_{OUT}$') ; et

un module (18) adapté à recevoir le signal numérique et le signal numérique filtré et à fournir un signal (SINAD) représentatif du rapport entre les puissances efficaces du signal numérique et du signal numérique filtré.

**2.** Dispositif selon la revendication 1, dans lequel le module (22) de fourniture du signal de test ($S_{IN}$) est adapté à fournir un signal comprenant seulement des composantes fréquentielles à la fréquence fondamentale ($F_{IN}$) et à des harmoniques impaires de la fréquence fondamentale.

**3.** Dispositif selon la revendication 1, dans lequel le module (22) de fourniture du signal de test ($S_{IN}$) est adapté à fournir un signal carré et périodique.

**4.** Dispositif selon la revendication 1, dans lequel le module (22) de fourniture du signal de test ($S_{IN}$) est adapté à fournir un signal dont la fréquence fondamentale est égale au quart ou à la moitié de la fréquence d'échantillonnage ($F_S$).

**5.** Dispositif selon la revendication 1, dans lequel le convertisseur (14) comprend un étage de filtrage (32) équivalent à un filtre passe-bas dont la fréquence de coupure ($F_C$) est égale à la moitié de la fréquence d'échantillonnage ($F_S$).

**6.** Dispositif selon la revendication 1, dans lequel le convertisseur (14) est du type sigma-delta.

**7.** Procédé de test d'un convertisseur analogique-numérique (14) fournissant un signal numérique ($S_{OUT}$) à une fréquence d'échantillonnage ($F_S$) donnée, comprenant l'étape suivante :

fournir au convertisseur un signal de test ($S_{IN}$), ledit procédé étant **caractérisé en ce que** le signal de test correspond à un signal périodique comportant des composantes fréquentielles seulement à une fréquence fondamentale ($F_{IN}$) et à des harmoniques, la fréquence fondamentale étant un multiple du quart de la fréquence d'échantillonnage ;

et **en ce qu'**il comprend les étapes suivantes :

filtrer le signal numérique pour rejeter la fréquence fondamentale ; et

déterminer le rapport entre les puissances efficaces du signal numérique et du signal numérique filtré ($S_{OUT}$').

**8.** Procédé selon la revendication 7, dans lequel le signal de test ($S_{IN}$) comprend seulement des composantes fréquentielles à la fréquence fondamentale ($F_{IN}$) et à des harmoniques impaires de la fréquence fondamentale.

**9.** Procédé selon la revendication 7, dans lequel la fréquence fondamentale ($F_{IN}$) est égale au quart ou à la moitié de la fréquence d'échantillonnage ($F_S$).

**10.** Procédé selon la revendication 7, dans lequel le convertisseur (14) réalise un filtrage du signal numérique ($S_{OUT}$) du type passe bas à une fréquence de coupure ($F_C$) égale à la moitié de la fréquence d'échantillonnage ($F_S$).

**Claims**

**1.** A device (20) for testing an analog-to-digital converter (14) providing a digital signal ($S_{OUT}$) at a given sampling frequency ($F_S$), comprising:

a unit (22) for providing a test signal ($S_{IN}$) to the converter, **characterized in that** the test signal is a periodic signal comprising frequency components only at a fundamental frequency ($F_{IN}$) and at harmonics of the fundamental frequency, the fundamental frequency being a multiple of one quarter of the sampling frequency;

and **in that** it comprises:

a filter (16) capable of receiving the digital signal and of rejecting the fundamental frequency to provide a filtered digital signal ($S_{OUT}$'); and

a unit (18) capable of receiving the digital signal and the filtered digital signal and of providing a signal (SINAD) representative of the ratio between the effective powers of the digital signal and of the filtered digital signal.

2.  The device of claim 1, wherein the unit (22) for providing the test signal ($S_{IN}$) is capable of providing a signal only comprising frequency components at the fundamental frequency ($F_{IN}$) and at odd harmonics of the fundamental frequency.

3.  The device of claim 1, wherein the unit (22) for providing the test signal ($S_{IN}$) is capable of providing a square periodic signal.

4.  The device of claim 1, wherein the unit (22) for providing the test signal ($S_{IN}$) is capable of providing a signal having its fundamental frequency equal to one quarter or to half of the sampling frequency ($F_S$).

5.  The device of claim 1, wherein the converter (14) comprises a filtering stage (32) equivalent to a low-pass filter having its cut-off frequency ($F_C$) equal to half of the sampling frequency ($F_S$).

6.  The device of claim 1, wherein the converter (14) is of sigma-delta type.

7.  A method for testing an analog-to-digital converter (14) providing a digital signal ($S_{OUT}$) at a given sampling frequency ($F_S$), comprising the step of:

    providing the converter with a test signal ($S_{IN}$),
    said method being **characterized in that** the test signal corresponds to a periodic signal comprising frequency components only at a fundamental frequency ($F_{IN}$) and at harmonics, the fundamental frequency being a multiple of one quarter of the sampling frequency;
    and **in that** it comprises the following steps:

    filtering the digital signal to reject the fundamental frequency; and
    determining the ratio between the effective powers of the digital signal and of the filtered digital signal ($S_{OUT}$').

8.  The method of claim 7, wherein the test signal ($S_{IN}$) only comprises frequency components at the fundamental frequency ($F_{IN}$) and at odd harmonics of the fundamental frequency.

9.  The method of claim 7, wherein the fundamental frequency ($F_{IN}$) is equal to one quarter or to half of the sampling frequency ($F_S$).

10. The method of claim 7, wherein the converter (14) performs a low-pass type filtering of the digital signal ($S_{OUT}$) at a cut-off frequency ($F_C$) equal to half of the sampling frequency ($F_S$).

**Patentansprüche**

1.  Eine Einrichtung (20) zum Testen eines Analog-zu-Digital-Konverters (14), ein digitales Signal ($S_{OUT}$) bei einer bestimmten Abtastfrequenz ($F_S$) vorsehend, wobei die Einrichtung Folgendes aufweist:

    eine Einheit (22) zum Vorsehen eines Testsignals ($S_{IN}$) für den Konverter, **dadurch gekennzeichnet dass** das Testsignal ein periodisches Signal ist, welches Frequenzkomponenten nur bei einer fundamentalen Frequenz ($F_{IN}$) und bei Harmonischen bzw. Oberwellen von der fundamentalen Frequenz aufweist, wobei die fundamentale Frequenz ein Vielfaches von einem Viertel von der Abtastfrequenz ist;
    und indem sie Folgendes aufweist:

    ein Filter (16), das geeignet ist zum Empfangen des digitalen Signals und zum Zurückweisen bzw. Unterdrücken der fundamentalen Frequenz zum Vorsehen eines gefilterten digitalen Signals ($S_{OUT}$'); und
    eine Einheit (18), die geeignet ist zum Empfangen des digitalen Signals und des gefilterten digitalen Signals und zum Vorsehen eines Signals (SINAD), welches repräsentativ ist für das Verhältnis zwischen den effektiven Leistungen von dem digitalen Signal und von dem gefilterten digitalen Signal.

2. Einrichtung nach Anspruch 1, wobei die Einheit (22) zum Vorsehen des Testsignals ($S_{IN}$) geeignet ist zum Vorsehen eines Signals, das nur Frequenzkomponenten bei der fundamentalen Frequenz ($F_{IN}$) und bei ungeraden Harmonischen von der fundamentalen Frequenz aufweist.

3. Einrichtung nach Anspruch 1, wobei die Einheit (22) zum Vorsehen des Testsignals ($S_{IN}$) geeignet ist zum Vorsehen eines rechteckigen periodischen Signals.

4. Einrichtung nach Anspruch 1, wobei die Einheit (22) zum Vorsehen des Testsignals ($S_{IN}$) geeignet ist zum Vorsehen eines Signals, dessen fundamentale Frequenz gleich einem Viertel oder einer Hälfte von der Abtastfrequenz ($F_S$) ist.

5. Einrichtung nach Anspruch 1, wobei der Konverter (14) eine Filterstufe (32) aufweist, die äquivalent zu einem Tiefpassfilter ist, dessen Grenzfrequenz ($F_C$) gleich der Hälfte der Abtastfrequenz ($F_S$) ist.

6. Einrichtung nach Anspruch 1, wobei der Konverter (14) ein Konverter vom Sigma-Delta-Typ ist.

7. Ein Verfahren zum Testen eines Analog-zu-Digital-Konverters (14), ein digitales Signal ($S_{OUT}$) bei einer bestimmten Abtastfrequenz ($F_S$) vorsehend, wobei das Verfahren den folgenden Schritt aufweist:

   Versehen des Konverters mit einem Testsignal ($S_{IN}$),

   wobei das Verfahren **dadurch gekennzeichnet ist, dass** das Testsignal einem periodischen Signal entspricht, das Frequenzkomponenten nur bei einer fundamentalen Frequenz ($F_{IN}$) und bei Harmonischen bzw. Oberwellen aufweist, wobei die fundamentale Frequenz ein Vielfaches von einem Viertel von der Abtastfrequenz ist; und **dadurch** dass das Verfahren die folgenden Schritte aufweist:

   Filtern des digitalen Signals zum Zurückweisen bzw. Unterdrücken der fundamentalen Frequenz; und Bestimmen des Verhältnisses zwischen den effektiven Leistungen von dem digitalen Signal und von dem gefilterten digitalen Signal ($S_{OUT}'$).

8. Verfahren nach Anspruch 7, wobei das Testsignal ($S_{IN}$) nur Frequenzkomponenten bei der fundamentalen Frequenz ($F_{IN}$) und bei geraden Harmonischen von der fundamentalen Frequenz aufweist.

9. Verfahren nach Anspruch 7, wobei die fundamentale Frequenz ($F_{IN}$) gleich einem Viertel oder der Hälfte von der Abtastfrequenz ($F_S$) ist.

10. Verfahren nach Anspruch 7, wobei der Konverter (14) eine tiefpassartige Filterung von dem digitalen Signal ($S_{OUT}$) bei einer Grenzfrequenz ($F_C$); gleich einer Hälfte von der Abtastfrequenz ($F_S$), ausführt.

Fig 1

Fig 2

Fig 3

Fig 4

Fig 5

Fig 6

Fig 7

Fig 8

Fig 9